(19) Europäisches Patentamt
European Patent Office
Office européen des brevets

(11) **EP 4 050 354 B1**

(12) **EUROPEAN PATENT SPECIFICATION**

(45) Date of publication and mention
of the grant of the patent:
**01.01.2025 Bulletin 2025/01**

(21) Application number: **21305220.2**

(22) Date of filing: **25.02.2021**

(51) International Patent Classification (IPC):
**G01R 31/34** *(2020.01)* **G01R 31/327** *(2006.01)*

(52) Cooperative Patent Classification (CPC):
**G01R 31/343; G01R 31/3277**

(54) **A METHOD AND A DEVICE FOR MONITORING THE CONDITION OF A MOTOR**

VERFAHREN UND VORRICHTUNG ZUR ÜBERWACHUNG DES ZUSTANDS EINES MOTORS

PROCÉDÉ ET DISPOSITIF DE SURVEILLANCE DE L'ÉTAT D'UN MOTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**31.08.2022 Bulletin 2022/35**

(73) Proprietors:
• **Mitsubishi Electric R & D Centre Europe B.V.
1119 NS Schiphol Rijk (NL)**
Designated Contracting States:
**FR**
• **Mitsubishi Electric Corporation
Tokyo 100-8310 (JP)**
Designated Contracting States:
**AL AT BE BG CH CY CZ DE DK EE ES FI GB GR
HR HU IE IS IT LI LT LU LV MC MK MT NL NO PL
PT RO RS SE SI SK SM TR**

(72) Inventors:
• **VOYER, Nicolas
35708 RENNES Cedex 7 (FR)**
• **ROJKO, Andreja
35708 RENNES Cedex 7 (FR)**

(74) Representative: **Cabinet Le Guen Maillet
3, impasse de la Vigie
CS 71840
35418 Saint-Malo Cedex (FR)**

(56) References cited:
CN-A- 106 680 700     US-A1- 2016 202 296
US-A1- 2019 028 044     US-A1- 2020 039 502

**Description**

TECHNICAL FIELD

The present invention relates generally to a method and a device for monitoring the condition of a motor.

RELATED ART

Condition monitoring of a motor is an important topic for the industry. Classically, the condition monitoring of a motor is performed by a spectral analysis of the motor current or of vibrations measured using external sensor.

The main approach in the literature consists in spectral analysis of motor current using Fast Fourier Transform (FFT). Motor current signature analysis (MCSA) methods detect the level of frequency spike at predetermined frequency locations, and by comparison, establish a fault level associated to each fault mode. The relation between a spike frequency and a fundamental frequency varies with the fault type and parameters of the motor. The spike level is proportional to the severity of the fault and also varies according to the operation point of the motor.

Some motors are driven by power sources, like for example inverters which have limited processing power capabilities, limited frequency operation and limited memory and limited storage capability. For these power sources, it is not possible to implement a Fast Fourier Transform processing without increasing the overall performance of the power source.

Power sources may be connected to any kind of motors. The spectral analysis is therefore difficult to be determined in absence of a knowledge of the detailed motor design. Thus, the spectral analysis must be adjusted to any possible motor type.

Spike harmonics vary with the operation point of the motor, the current waveform used for driving the motor. It is therefore difficult to establish a general analytic formula which enables a condition monitoring of any type of motor.

The patent application CN 106 680 700 discloses an isolation switch intelligence diagnosis system and method thereof.

SUMMARY OF THE INVENTION

The present invention aims to provide a method for monitoring the condition of a motor without using any complex frequency signal processing like for example using Fast Fourier Transform and which can operate with any type of motor.

To that end, the present invention concerns a method for monitoring the condition of a motor, wherein the method is implemented by the apparatuses of the invention and the motor is driven by a power source that provides signals to the motor, wherein the method comprises the steps of:

- sensing a motor signal,
- detecting operating conditions of the motor, and if the motor operates in predetermined conditions:
- detecting the instants of zero-crossing of the sensed signal,
- determining the time intervals between two zero-crossing instants,
- estimating plural envelopes of the determined time intervals in order to obtain an estimated pattern of envelopes, each envelope being determined over a number of determined time intervals,
- determining from the operating conditions of the motor and the pattern of envelopes if the motor has a fault and/or a level of the fault.

The present invention concerns also a device for monitoring the condition of a motor, the motor being driven by a power source that provides signals to the motor, wherein the device comprises:

- means for sensing a motor signal,
- means for detecting operating conditions of the motor, and if the motor operates in predetermined conditions:
- means for detecting the instants of zero-crossing of the sensed signal,
- means for determining the time intervals between two zero-crossing instants,
- means for estimating plural envelopes of the determined time intervals in order to obtain a pattern of envelopes, each envelope being determined over a number of determined time intervals,
- means for determining from the operating conditions of the motor and the pattern of envelopes if the motor has a fault and/or a level of the fault.

The present invention concerns also a system for monitoring the condition of a motor, the motor being driven by a power source that provides signals to the motor, wherein the system comprises:

- means, included in the device for monitoring the condition of a motor, for sensing a motor signal,
- means, included in a device for monitoring the condition of a motor, for detecting operating conditions of the motor, and if the motor operates in predetermined conditions:

  - means, included in the device for monitoring the condition of a motor, for detecting the instants of zero-crossing of the sensed signal,
  - means, included in the device for monitoring the condition of a motor, for determining the time intervals between two zero-crossing instants,
  - means, included in the device for monitoring the condition of a motor, for estimating plural envelopes of the determined time intervals in order to obtain a pattern of envelopes, each envelope being determined over a number of determined time intervals,
  - means, included in the device for monitoring the condition of a motor, for transferring to a server through a communication network the estimated envelopes, the operating conditions of the motor and information identifying the motor.
  - means, included in the server, for determining from the operating conditions of the motor and the pattern of envelopes if the motor has a fault and/or a level of the fault.

Thus, as the pattern is determined under predetermined conditions, it can be determined from the predetermined operating conditions of the motor and the pattern of envelopes if the motor has a fault and/or a level of the fault.

The pattern is composed of few envelope points, it requires very small storage resource comparing to data storage resources required in conventional methods, and its transmission to a server requires very limited communication bandwidth.

Despite its small size in number of envelope points, the pattern covers a time window of relatively large duration, because each envelope point is built from a large number of time intervals. As each time interval is determined from sensed signal values, one envelope points covers a signal duration that is typically much longer than the time between 2 consecutive signal values. The detection of envelope points effectively reduces the amount of data, resulting in reduced storage and communication requirements.

Despite the drastic reduction of information resulting from the invention, the pattern of envelope points still contains information resulting from the presence of at least one frequency spike, superposed to the fundamental and high frequency current signal resulting from the Pulse Width Modulation operation of the power source.

The pattern is affected by the cross-talk between such signals that result from undersampling. The presence of cross-talk produces low frequency oscillations of the envelope that can be detected without high sampling requirement.

The zero-current timing intervals is affected by the superposition of various frequency components of the sensed signal.

According to a particular feature, the step of determining if the motor has a fault and/or a level of the fault is performed by comparing, if a pattern of envelopes with same predetermined operating conditions is memorized, the estimated pattern of envelopes to the memorized pattern of envelopes with same predetermined operating conditions.

Thus, the measured pattern and reference patterns are comparable, as collected under same operating conditions. Difference between patterns reflects a presence of fault, and also reflects the level of the fault.

According to a particular feature, the method further comprises the step of memorizing the estimated pattern of envelopes if no pattern of envelopes with same predetermined operating conditions is memorized.

Thus, at the setup of a new motor, the method can establish some reference pattern in various predetermined conditions. Later, in presence of fault, the reference pattern and a new measured pattern can be compared, from which a fault and/or a fault level can be determined. The invention requires no complex setting of test setup to acquire patterns in known fault condition. The invention can operate in a plug-and-play manner, without any a priori knowledge of the design of the motor.

According to a particular feature, the step of determining if the motor has a fault and/or a level of the fault is performed using a neural network and weights used by the neural network are received by a server.

Thus, the measured pattern is not only compared with one reference pattern, but with many patterns in a variety of operating conditions. When the neural network is trained with patterns measured under known fault conditions (fault type and fault level), the neural network can predict the fault type and the fault presence also from patterns measured with operating conditions not covered by the set on patterns used for the training. The number of patterns needed to implement reliable detection of faults using the invention is reduced.

Neural network is very robust and needs no engineering related to characterization of the fault type and the level of fault level from the shape of measured pattern. The neural network is trained to deliver correct decisions on known sequences with and without fault, and with different known levels of fault, even though there is no clear analytical relationship between measured pattern and fault type and fault level.

The fault analysis decision on a given motor is helped by the analysis of patterns realized on other similar motors and similar operating conditions.

The neural network can compare the estimated pattern at measured predetermined operating condition with other patterns estimated at other predetermined conditions, without or with known fault types and fault level. The other patterns combined with other predetermined operating conditions and known fault levels are typically used to train the neural network. The training is realised in the distant server and needs not be realised in the device for monitoring the condition of a motor.

After training of the neural network, the weights of the neural network are received by the device for monitoring the condition of a motor. The device for monitoring the condition of a motor can build a decision from the estimated pattern and from the predetermined operating conditions. The decision is fully decentralised and robust. The method is effective while using very limited computations, memory usage, communication bandwidth.

The presence of fault can be determined from neighbour predetermined operating conditions, even when no pattern was measured under the predetermined operating conditions.

Furthermore, the neural network can determine a level of fault from the estimated pattern, even though the design details of machine are unknown. The signature of fault, caused by the cross talk between fault spike frequency, fundamental frequency, and Pulse Width Modulation frequency, is automatically associated to fault type and fault level, as Neural network minimises the distance of estimated pattern at predetermined operating conditions with patterns with known fault type and fault level at other neighbouring predetermined operating conditions.

According to an implementation, the method is executed by the device for monitoring the condition of a motor.

Thus, the device for monitoring the condition of a motor can detect the fault without any assistance from an external device. The invention requires no communication with external processing unit, and the fault can be detected and localised locally on the location site of the motor. The invention is then decentralised and robust.

According to a particular feature, the steps of sensing a motor signal, detecting predetermined operating conditions of the motor, detecting the instants of zero-crossing of the sensed signal, determining the time intervals between two zero-crossing instants, estimating plural envelopes of the determined time intervals in order to obtain a pattern of envelopes are executed by a device for monitoring the condition of a motor.

Thus, the pattern information is of limited size, and needs to be analysed at a very slow pace. When the step for determining if the motor has a fault is implemented in an external processing unit, the amount of transferred data to the external processing unit is reduced drastically.

The device for monitoring the condition of a motor has marginal CPU and communication costs. It does not need to sense signals with high frequency bandwidth. It does not need to store large amount of signals. It does not need to implement complex operations such as FFT. It does not need to evaluate the spectrum components over a variety of candidate faults. It does not need to know about the machine design parameter to determine the frequency components that should be evaluated. It does not need to communicate large signal vectors to an external processing units with large processing capabilities.

The device for monitoring the condition of a motor can easily be integrated in commercial power source, such as general purpose inverters or power supply, without change of hardware (memory, analog-to-digital converters, CPU, communication).

According to a particular feature, the method comprises further step of transferring to a server through a communication network the estimated envelopes, the operating conditions of the motor and information identifying the type of motor.

Thus, in absence of fault, the pattern can be shared with a server controlling many motors of the same or different types. The pattern collected for one motor may serve as a reference for checking the patterns detected on other motors of the same type on similar operating conditions. The device for monitoring the condition of a motor needs not to store reference pattern over large number of predetermined operation conditions.

According to a particular feature, the step of determining from the operating conditions of the motor and the pattern of envelopes if the motor has a fault and/or a level of the fault is executed by the server.

Thus, the server can compare the determined pattern with patterns previously reported by other devices controlling the same type of motor on similar predetermined conditions. The server can also get trained with a large number of patterns for known fault conditions.

The accuracy of fault level detection on the measured pattern is increased using measured patterns under known fault conditions. The identification of the fault type (e.g. mixed eccentricity, bearing inner/outer race, etc) is also improved.

According to a particular feature, the step of determining from the operating conditions of the motor and the pattern of envelopes if the motor has a fault and/or a level of the fault is performed by a neural network comprised in the server.

Thus, the device for monitoring the condition of a motor does not need to comprise a neural network. The neural network located at the server can monitor the condition of many motors of same type, and needs no replication over a fleet of motors, saving computing and memory resource. The server can collect the fault type and faul levels of a fleet of motors and use this information to better prepare for the maintenance of faulty motors within the fleet of motors.

BRIEF DESCRIPTION OF THE DRAWINGS

The characteristics of the invention will emerge more clearly from a reading of the following description of example embodiments, the said description being produced with reference to the accompanying drawings, among which:

Fig. 1a represents an architecture of a system for driving a motor and for monitoring the condition of the motor according to a first mode of realization of the present invention;
Fig. 1b represents an architecture of a system for driving a motor and for monitoring the condition of the motor according to a second mode of realization of the present invention;
Fig. 2 represents an architecture of a device for monitoring the condition of a motor;
Fig. 3 represents an architecture of a server for monitoring the condition of at least one motor;
Fig. 4 represents a first example of an algorithm, executed by a device for monitoring the condition of a motor, for monitoring the condition of the motor according to the first mode of realization of the present invention;
Fig. 5 represents an example of an algorithm, executed by a device for monitoring the condition of a motor, for monitoring the condition of the motor according to the second mode of realization of the present invention;
Fig. 6 represents a first example of an algorithm executed by a server for monitoring the condition of at least one motor;
Fig. 7 represents a second example of an algorithm executed by a server for monitoring the condition of at least one motor;
Fig. 8 represents an example of the waveform of a motor signal representing the current flowing through one phase of the motor surimposed by a corresponding ideal sinusoidal waveform;
Fig. 9 represents a chronogram of time intervals between zero-crossing instants determined according to the invention.
Fig. 10a represents a waveform representing time intervals between zero-point instants when the motor has no default;
Fig. 10b represents a pattern of envelopes obtained according to the invention when the motor has no default;
Fig. 11a represents a waveform representing time intervals between zero-point instants when the motor has at least one default;
Fig. 11b represents a pattern of envelopes obtained according to the invention when the motor has at least one default;
Fig. 12 represents a neural network implementation of the step for determining from the operating conditions of the motor and the estimated pattern of envelopes if the motor has a fault and/or a level of the fault;
Fig. 13 represents a second example of an algorithm, executed by a device for monitoring the condition of a motor, for monitoring the condition of the motor according to the second mode of realization of the present invention.

DESCRIPTION

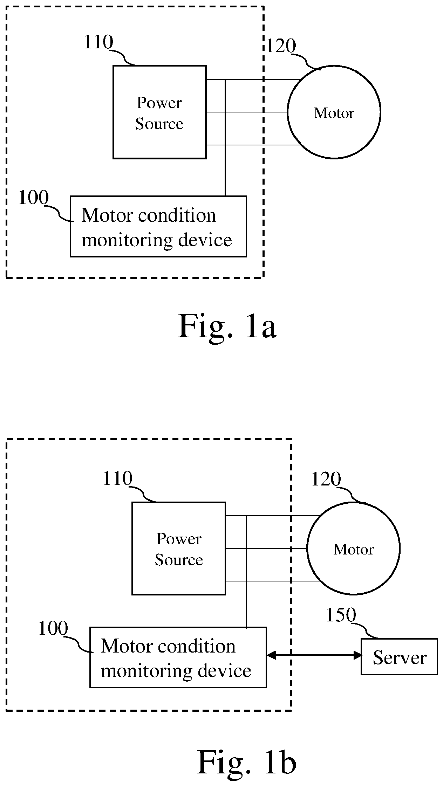

Fig. **1a** represents an architecture of a system for driving a motor and for monitoring the condition of the motor according to a first mode of realization of the present invention.
The system for driving a motor and for monitoring the condition of the motor comprises a motor 120 that is driven by a power source 110 that provides current to the motor.
The system further comprises a device for monitoring the condition of a motor 100 that senses a motor signal representative of the current flowing through one phase connector of the motor 120 and processes sensed signal values.
The sensed motor signal is for example the level of current flowing through one phase of the motor, or the control voltage applied by the power source 110 between two phases of the motor or between one phase of the motor and the ground of power source 110, or a level of stray flux measured at the vicinity of the motor 120.
The sensed signal values are sensed as example at switching frequency of power source 110.
According to the first mode of realization, the device for monitoring the condition of a motor 100:

-   senses a motor signal,
-   detects operating conditions of the motor, and if the motor operates in predetermined conditions:
-   detects the instants of zero-crossing of the sensed signal,
-   determines the time intervals between two zero-crossing instants,
-   estimates plural envelopes of the determined time intervals in order to obtain a pattern of envelopes, each envelope being determined over a number of determined time intervals,
-   determines from the operating conditions of the motor and the pattern of envelopes if the motor has a fault and/or a level of the fault.

According to a variant of invention, the motor condition monitoring device 100 is comprised in the power source 110.

The power source 110 may be a general purpose inverter, or a commercial power supply.

**Fig. 1b** represents an architecture of a system for driving a motor and for monitoring the condition of the motor according to a second mode of realization of the present invention.

The system for driving a motor and for monitoring the condition of the motor comprises a motor 120 that is driven by a power source 110 that provides current to the motor.

The system further comprises a device for monitoring the condition of a motor 100 that senses a signal representative of current flowing through one phase connector of the motor 120, processes sensed signal values and transfers the processed signal values to a server 150 though a communication network not shown in Fig. 1b.

The sensed signal is for example the phase current level, or the phase control voltage applied by the power source 110, or a level of stray flux measured at the vicinity of the motor 120.

The signal values are sensed as example at switching frequency of the power source 110.

The communication network is for example a wireless or a wired network or a combination of wireless and wired communication network.

The server 150 is able to determine, from the received processed signal values, if the motor 120 has a default or not, and the level of the corresponding default.

According to a variant of invention, the motor condition monitoring device 100 is comprised in the power source 110.

The power source 110 may be a general purpose inverter, or a commercial power supply.

According to the second mode of realization, the device for monitoring the condition of a motor 100:

- senses a motor signal,
- detects operating conditions of the motor, and if the motor operates in predetermined conditions:
- detects the instants of zero-crossing of the sensed signal,
- determines the time intervals between two zero-crossing instants,
- estimates plural envelopes of the determined time intervals in order to obtain a pattern of envelopes, each envelope being determined over a number of determined time intervals,
- transfers the pattern of envelopes to the server.

The server:

- receives pattern of envelopes from a least one device for monitoring the condition of a motor 100,
- determines from the operating conditions of the motor and the pattern of envelopes if the motor has a fault and/or a level of the fault.

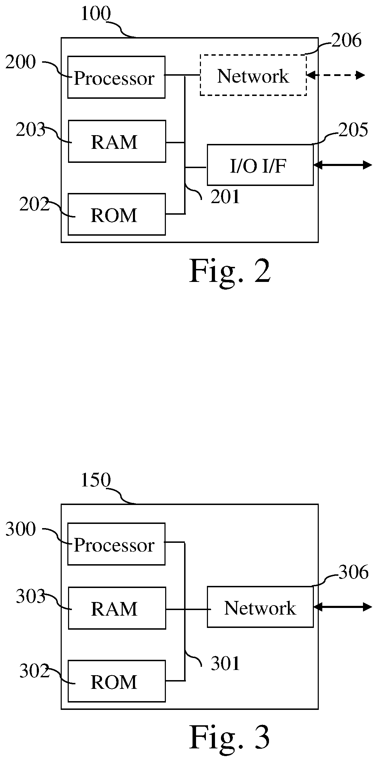

**Fig. 2** represents an architecture of a device for monitoring the condition of a motor.

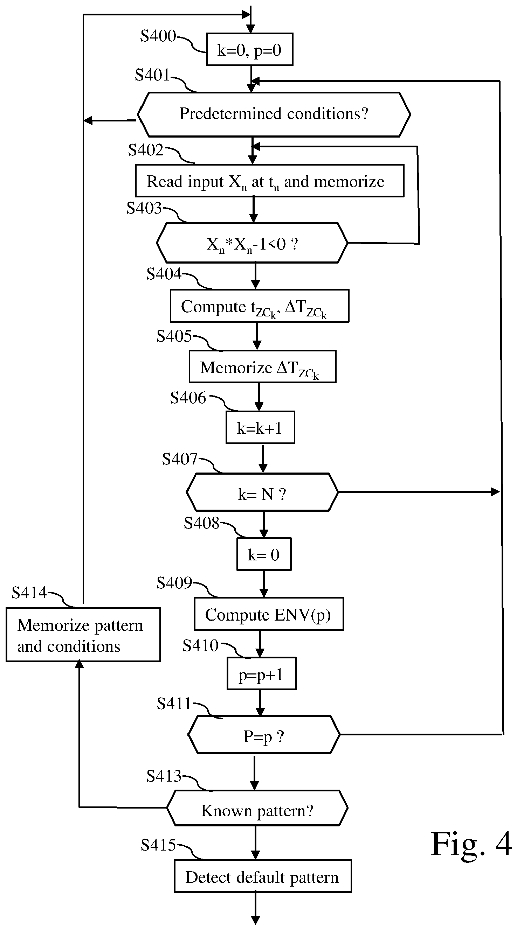

The device for monitoring the condition of a motor 100 has, for example, an architecture based on components connected together by a bus 201 and a processor 200 controlled by a program as disclosed in Fig. 4 or 5 or 13.

The bus 201 links the processor 300 to a read only memory ROM 202, a random access memory RAM 203, an input output I/O IF interface 205 and according to the scond mode of realization of the invention a network interface 206.

The input output I/O IF interface 205 enables the device for monitoring the condition of a motor 100 to sense signals representative of current flowing through one phase connector of the motor 120.

The network interface 206 enables the device for monitoring the condition of a motor 100 to transfer processed signal values to the server 150.

The memory 203 contains registers intended to receive variables and the instructions of the program related to the algorithm as disclosed in Fig. 4 or 5 or 13.

The read-only memory, or possibly a Flash memory 202, contains instructions of the programs related to the algorithm as disclosed in Fig. 4 or 5 or 13, when the device for monitoring the condition of a motor 100 is powered on, are loaded to the random access memory 203. Alternatively, the program may also be executed directly from the ROM memory 202.

The calculation performed by the device for monitoring the condition of a motor 100 may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array)* or an ASIC (*Application-Specific Integrated Circuit*).

In other words, the device for monitoring the condition of a motor 100 includes circuitry, or a device including circuitry, causing the device for monitoring the condition of a motor 100 to perform the program related to the algorithm as disclosed in Fig. 4 or 5 or 13.

**Fig. 3** represents an architecture of a server for monitoring the condition of at least one motor.

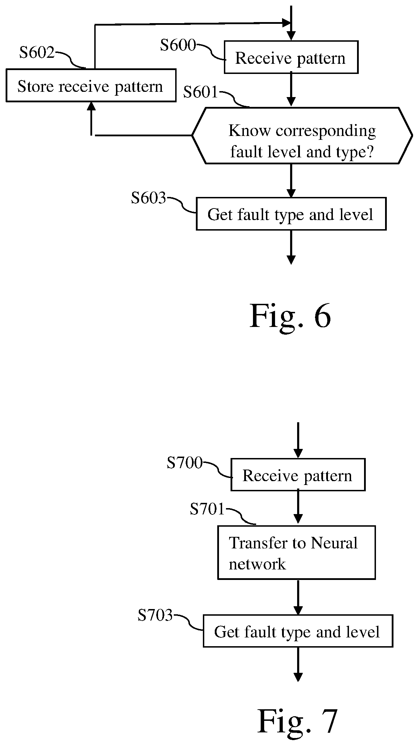

The server 150 for monitoring the condition of a motor 100 has, for example, an architecture based on components connected together by a bus 301 and a processor 300 controlled by a program as disclosed in Fig. 6 or 7.

The bus 301 links the processor 300 to a read only memory ROM 302, a random access memory RAM 303 and network interface 306.

The network interface 306 enables the server 150 to receive processed signal values from at least one device for monitoring the condition of a motor 100.

The memory 303 contains registers intended to receive variables and the instructions of the program related to the algorithm as disclosed in Fig. 6 or 7.

The read-only memory, or possibly a Flash memory 302, contains instructions of the programs related to the algorithm as disclosed in Fig. 6 or 7, when the server 150 is powered on, are loaded to the random access memory 303. Alternatively, the program may also be executed directly from the ROM memory 302.

The calculation performed by the server 150 may be implemented in software by execution of a set of instructions or program by a programmable computing machine, such as a PC *(Personal Computer)*, a DSP *(Digital Signal Processor)* or a microcontroller; or else implemented in hardware by a machine or a dedicated component, such as an FPGA *(Field-Programmable Gate Array)* or an ASIC *(Application-Specific Integrated Circuit)*.

In other words, the server 150 includes circuitry, or a device including circuitry, causing the server 150 to perform the program related to the algorithm as disclosed in Fig. 6 or 7.

**Fig. 4** represents a first example of an algorithm, executed by a device for monitoring the condition of a motor, for monitoring the condition of the motor according to the first mode of realization of the present invention.

The present algorithm is disclosed in an example wherein it is executed by the processor 200 of the device for monitoring the condition of a motor 100.

At step S400, the processor 200 sets the variables k and p to null value.

At next step S401, the processor 200 checks if the motor operates in predetermined conditions. For example, predetermined operating conditions are constant speed and torque. The processor 200 detects the variation of speed and torque from the variation of average frequency and amplitude of the sensed signal. The motor is in predetermined operating conditions when the frequency and amplitude of the sensed signal are stable.

As example, an operating condition is stable when its distance to its average value is less than 5% of the average value.

In a variant, the predetermined operating conditions are constant torque and constant speed ramp. In yet another variant, the predetermined operating conditions are cyclic speed and torque.

If the motor is in predetermined operating conditions, the processor 200 moves to step S402. Otherwise, the processor 200 returns to step S400.

At step S402, the processor 200 obtains from the I/O interface 205 at time $t_n$ the signal value noted $X_n$ representative of the current flowing through one phase connector of the motor 120 where n is an indicia that is incremented each time the signal value is sensed and memorizes $t_n$ and $X_n$.

It has to be noted here that the step S402 may be executed prior to step S401 and the signal value is used to determine if the motor operates in predetermined conditions.

At next step, S403 checks if the signs of the current value $X_n$ and of current value $X_{n-1}$ obtained at the previous iteration are different.

If the signs of the current values $X_n$ and $X_{n-1}$ are different, a zero-crossing of signal $X_n$ is detected and the processor 200 moves to step S404. Otherwise, the processor 200 returns to step S402 in order to measure following currents values $x_{n+1}$.

At step S404, the processor 200 calculates the zero-crossing instant $t_{zCk}$ and the time interval $\Delta T_{zCk}$ between the zero-crossing instant and the previously calculated zero-crossing instant:

$$t_{zC_k} = t_{n-1} - \frac{t_n - t_{n-1}}{X_n - X_{n-1}} X_{n-1}$$

$$\Delta T_{zC_k} = t_{zC_k} - t_{zC_{k-1}}$$

At next step S405, the processor 200 memorizes the time difference $\Delta T_{zCk}$.

At next step S406, the processor 200 increments the variable k by one.

A next step S407, the processor 200 checks if the variable k is equal to a first predetermined value N. For example, N is equal to 50.

In a variant, the predetermined value is computed from the speed of the predetermined conditions estimated at step S401, so that N consecutive zero-crossing corresponds to a fixed duration. As example, the fixed duration is one second.

If the variable k is equal to N, the processor 200 moves to step S408. Otherwise, the processor 200 returns to step S401.

At step S408, the processor 200 sets the variable k to null value.

At step S409, the processor 200 determines an envelope ENV(p) of the N time intervals $\Delta T_{zCk}$. As example, the envelope is the standard deviation:

$$ENV(p) = \sqrt{\frac{1}{N-1}\sum_{k \leq N}\left(\Delta T_{zC_k} - \frac{1}{N}\sum_{k \leq N}\Delta T_{zC_k}\right)^2}$$

As another example, the envelope is the maximum among the N intervals $\Delta T_{zCk}$.

At step S410, the processor 200 increments the variable p by one.

A next step S411, the processor 200 checks if the variable p is equal to a second predetermined value P. P is for example equal to 20.

If p is equal to P, the processor 200 moves to step S413. Otherwise, the processor 200 returns to step S401.

At step S413, a pattern of P stored envelopes values is obtained. The processor 200 checks if there is a pattern $ENV_{ref}$ already stored with the same predetermined motor conditions as one existing during the obtention of the obtained P stored envelopes values.

If there is no pattern already stored with the same predetermined operating conditions as one existing during the obtention of the obtained P stored envelopes values, the processor 200 moves to step S414. Otherwise, the processor 200 moves to step S415.

At step S414, the processor 200 stores the obtained P stored envelopes values together with the motor conditions and returns to step S400.

At step S415, the processor 200 determines if a fault exists for the motor for example by calculating a fault value as:

$$F = F_{ref}\frac{\max(\{ENV_p\})}{\max(\{ENV_{ref}\})}$$

Where $F_{ref}$ is a predetermined fault level, as example corresponding to the eccentricity tolerance of the machine.

In another variant:

$$F = F_{ref}\frac{\max(\{ENV_p\}) - \min(\{ENV_p\})}{\max(\{ENV_{ref}\}) - \min(\{ENV_{ref}\}}$$

As example, $F_{ref}$=5%. F represents the level of the detected Fault. The level of the fault is displayed when it exceeds a predetermined level (e.g. 10%, 20%, etc.).

In a variant, the processor 200 feeds a neural network with the detected pattern and the predetermined conditions. The neural network outputs the presence of a fault and the level of fault.

If a fault exists, a fault signal like a sound or a visual signal is generated.

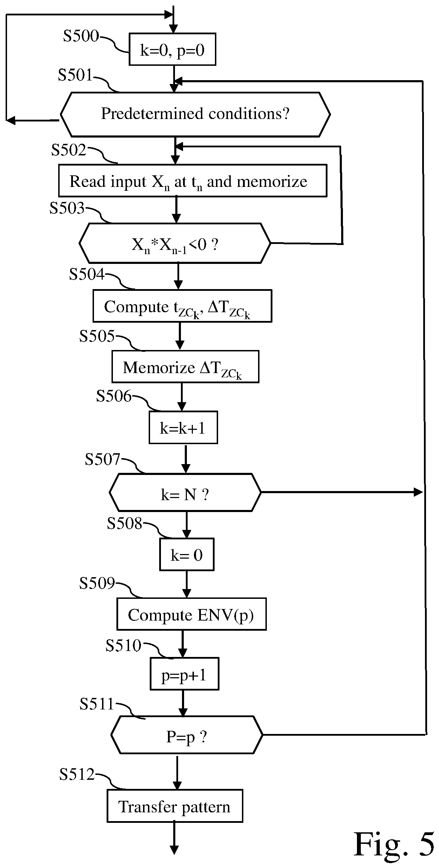

**Fig. 5** represents an example of an algorithm, executed by a device for monitoring the condition of a motor, for monitoring the condition of the motor according to the second mode of realization of the present invention.

The present algorithm is disclosed in an example wherein it is executed by the processor 200 of the device for monitoring the condition of a motor 100.

At step S500, the processor 200 sets the variables k and p to null value.

At next step S501, the processor 200 checks if the motor operates in predetermined conditions. For example, operating stable conditions are constant speed and torque. The processor 200 detects the variation of speed and torque from the variation of average frequency and amplitude of the sensed signal. The motor is in predetermined operating conditions when the average frequency and amplitude of the sensed signal are stable.

In a variant, the predetermined operating conditions are constant torque and constant speed ramp. In yet another variant, the predetermined operating conditions are cyclic speed and torque.

If the motor is in predetermined operating conditions, the processor 200 moves to step S502. Otherwise, the processor 200 returns to step S500.

At step S502, the processor 200 obtains from the I/O interface 205 at time $t_n$ the signal value noted $X_n$ representative of the current flowing through one phase connector of the motor 120 where n is an indicia that is incremented each time the signal value is sensed and memorizes $t_n$ and $X_n$.

It has to be noted here that the step S502 may be executed prior to step S501 and the signal value is used to determine if the motor operates in predetermined conditions.

At next step, S503 checks if the signs of the current value $X_n$ and of current value $X_{n-1}$ obtained at the previous iteration are different.

If the signs of the current values $X_n$ and $X_{n-1}$ are different, a zero cross voltage is detected and the processor 200 moves to step S504. Otherwise, the processor 200 returns to step S502 in order to read following currents values $x_{n+1}$.

At step S504, the processor 200 calculates the zero-crossing instant $t_{zCk}$ and the time interval $\Delta T_{zCk}$ between the zero-crossing instant and the previously calculated zero-crossing instant:

$$t_{zC_k} = t_{n-1} - \frac{t_n - t_{n-1}}{X_n - X_{n-1}} X_{n-1}$$

$$\Delta T_{zC_k} = t_{zC_k} - t_{zC_{k-1}}$$

At next step S505, the processor 200 memorizes the time difference $\Delta T_{zCk}$.

At next step S506, the processor 200 increments the variable k by one.

A next step S507, the processor 200 checks if the variable k is equal to a first predetermined value N. For example, N is equal to 50.

In a variant, the predetermined value is computed from the speed of the predetermined conditions estimated at step S501, so that N consecutive zero-crossing corresponds to a fixed duration. As example, the fixed duration is one second.

If the variable k is equal to N, the processor 200 moves to step S508. Otherwise, the processor 200 returns to step S501.

At step S508, the processor 200 sets the variable k to null value.

At step S509, the processor 200 determines an envelope ENV(p) of the N time intervals $\Delta T_{zCk}$. As example, the envelope is the standard deviation:

$$ENV(p) = \sqrt{\frac{1}{N-1} \sum_{k \leq N} \left( \Delta T_{zC_k} - \frac{1}{N} \sum_{k \leq N} \Delta T_{zC_k} \right)^2}$$

As another example, the envelope is the maximum among the N intervals $\Delta T_{zCk}$.

At step S510, the processor 200 increments the variable p by one.

A next step S511, the processor 200 checks if the variable p is equal to a second predetermined value P. P is for example equal to 20.

If p is equal to P, the processor 200 moves to step S512. Otherwise, the processor 200 returns to step S501.

At step S512, a pattern of P stored envelopes values is obtained. The processor 200 commands the transfer of message comprising the pattern of P stored envelopes values to the server 150 through the network interface 206 together with information identifying the motor and the motor conditions in which the pattern of P stored envelopes values have been obtained.

**Fig. 6** represents a first example of an algorithm executed by a server for monitoring the condition of at least one motor.

The present algorithm is disclosed in an example wherein it is executed by the processor 300 of the server 150.

At step S600, the processor 300 checks the reception of message comprising a pattern of P stored envelopes values through the network interface 306 together with information identifying the motor type, the motor itself and the motor conditions in which the pattern of P stored envelopes values have been obtained.

At step S601, the processor 300 checks if a pattern of P stored envelopes values with information identifying the motor type and the motor conditions in which the pattern of P stored envelopes values have been obtained is memorized in the RAM memory 302.

If a pattern $ENV_{ref}$ of P stored envelopes values with information identifying the motor type and the motor conditions in which the pattern of P stored envelopes values have been obtained is memorized in the RAM memory 302, the processor 300 moves to step S603. Otherwise, the processor 300 moves to step S602.

At step S602, the processor 300 stores the received P envelopes values together with the motor conditions and returns to step S600.

At step S603, the processor 300 determines if a fault exists for the motor for example by calculating a fault value as:

$$F = F_{ref} \frac{\max(\{ENV_p\})}{\max(\{ENV_{ref}\})}$$

Where $F_{ref}$ is a predetermined fault level, corresponding to the tolerance of the machine.

In another variant:

$$F = F_{ref} \frac{\max(\{ENV_p\}) - \min(\{ENV_p\})}{\max(\{ENV_{ref}\}) - \min(\{ENV_{ref}\}}$$

As example, $F_{ref}$=5%. F represents the level of the detected Fault. The level of the fault is displayed when it exceeds a predetermined level (e.g. 10%, 20%, etc.).

If a fault exists, a message is transferred to the device which transferred the pattern received at step S600.

**Fig. 7** represents a second example of an algorithm executed by a server for monitoring the condition of at least one motor.

The present algorithm is disclosed in an example wherein it is executed by the processor 300 of the server 150.

At step S700, the processor 300 receives a message comprising a pattern of P stored envelopes values through the network interface 306 together with information identifying the motor type, the motor itself and the motor conditions in which the pattern of P stored envelopes values have been obtained.

At step S701, the processor 300 transfers the received P stored envelopes values together with the motor conditions to a neural network comprised in the server 150.

At step S702, the processor 300 receives, from the neural network, information indicating if a fault exists for the motor.

If a fault exists, a message is transferred to the device which transferred the pattern received at step S700.

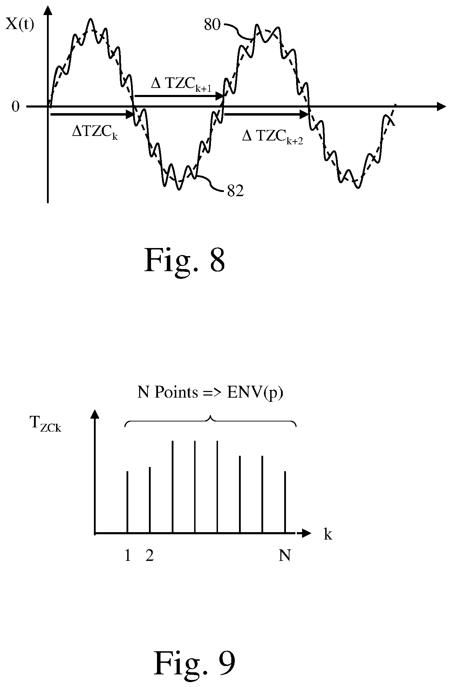

**Fig. 8** represents an example of the waveform of a motor signal representing the current flowing through one phase of the motor surimposed by a corresponding ideal sinusoidal waveform.

In the Fig. 8, the curve noted 80 represents the theorical current flowing through one phase of the motor 120 and the curve noted 82 represents spikes harmonics that are generated when a fault occurs in the motor 120 and in presence of pulse width modulation of the power source 110. A fault is for example and in a non-limitative way due to static or dynamic eccentricity, broken rotor bar, inner and outer bearing race.

Each fault has a specific frequency signature, meaning that the frequency spike due to the fault is proportional to the fundamental frequency times a ratio that depends on the fault type and on the motor 120 design parameter and operation mode. Over the lifetime of the motor 120, the fault level increases, meaning that the amplitude of the frequency increases, but the spike frequency remains constant. As the amplitudes, the intervals between zero-crossing points of the motor signal vary.

According to the invention, the variation of the time between zero-crossing is used as an input for determining if a fault appears in the motor 120.

$\Delta T_{ZCk}$, $\Delta T_{ZCk+1}$ and $\Delta T_{ZCk+2}$, denote measurement of time intervals between two zero-crossings.

In Fig 8. time intervals are measured between two consecutive zero-crossing, the invention equally applies when time intervals are measured between more than two consecutive zero-crossings.

**Fig. 9** represents a chronogram of time intervals between zero-crossing instants determined according the invention.

For example, the number of revolutions per second is equal to 100, the sampling frequency of the signal provided to the motor is equal to 5 KHz. N detections of zero point crossings are shown in Fig. 9. The N detections are used to determine one envelope point as disclosed at step S409 of Fig. 4 and S509 of Fig. 5. For example N= 50 and P equal 50.

It has to be noted here that N may be adapted with rotational speed of the motor 120 in order to keep constant the pattern duration and pattern size.

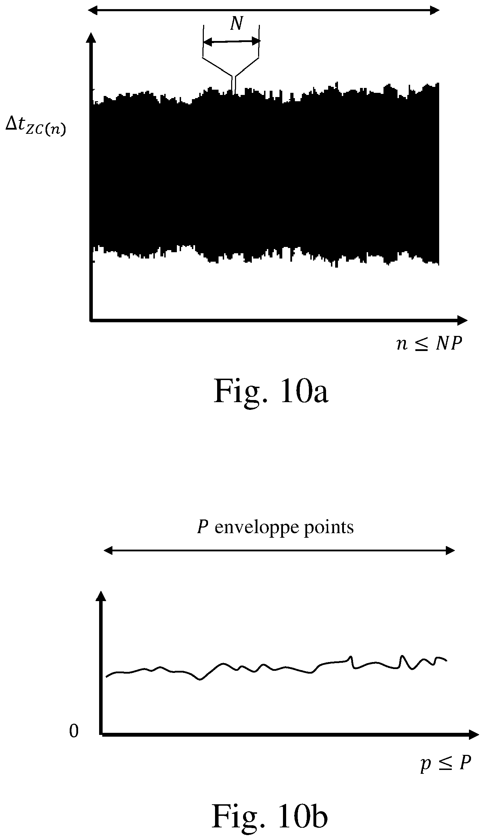

**Fig. 10a** represents a waveform representing time intervals between zero-point instants when the motor has no default.

According to the invention, the time differences $\Delta T_{zCk}$ between two zero-crossing instants are used to determined P envelopes.

In absence of fault, the time differences $\Delta T_{zCk}$ vary uniformly between two values. This oscillation results from the presence of HF current ripple due to the PWM switching of the power source. For same operating conditions, the resulting pattern is repeatable in absence of fault, and the envelope signal is quite constant.

**Fig. 10b** represents a pattern of envelopes obtained according to the invention when the motor has no default. The method effectively detects a rather constant envelope signal, representative of absence of fault.

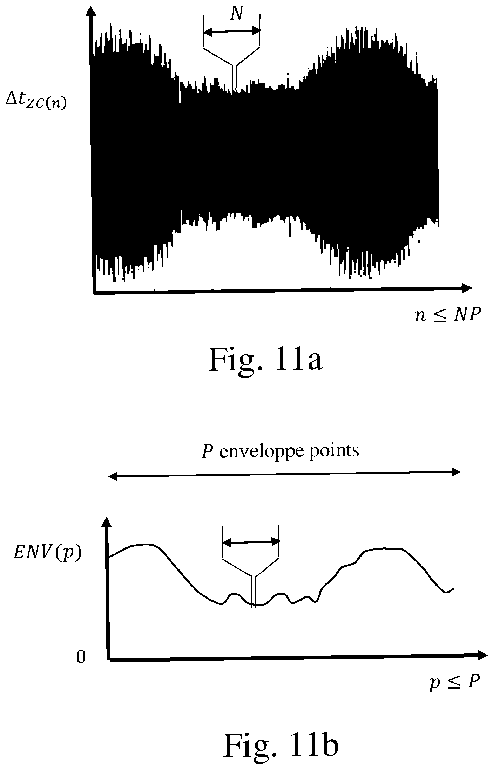

**Fig. 11a** represents a waveform representing time intervals between zero-point instants when the motor has at least one default.

According to the invention, the time differences $\Delta T_{zCk}$ between two zero-crossing instants are used to determined P envelopes.

In presence of fault, the time difference $\Delta T_{zCk}$ varies locally between 2 values. This oscillation results from the combined presence of HF current ripple due to PWM switching of the power source, and HF current spike resulting from the presence of the fault. Interference between HF PWM current and HF fault current causes low-frequency fluctuation of these two values.

**Fig. 11b** represents a pattern of envelopes obtained according to the invention when the motor has at least one default.

By comparing curves of Figs. 10b and 11b, variations of P envelopes are different.

The low-frequency fluctuation of envelope is representative of a fault type and/or a fault level. The level of fault can be determined from the frequency and height of envelope fluctuations.

In a first implementation of the invention, the fault level is determined as the ratio between envelope peaks times a predetermined initial fault level. If the estimated fault level is below 10%, the fault is considered not detected.

In a second implementation of invention, the fault level is determined as the ratio between the maximum and minimum envelope levels times a predetermined fault level.

In a third implementation of invention, the period and shape of pattern contributes to the identification of the fault type and level.

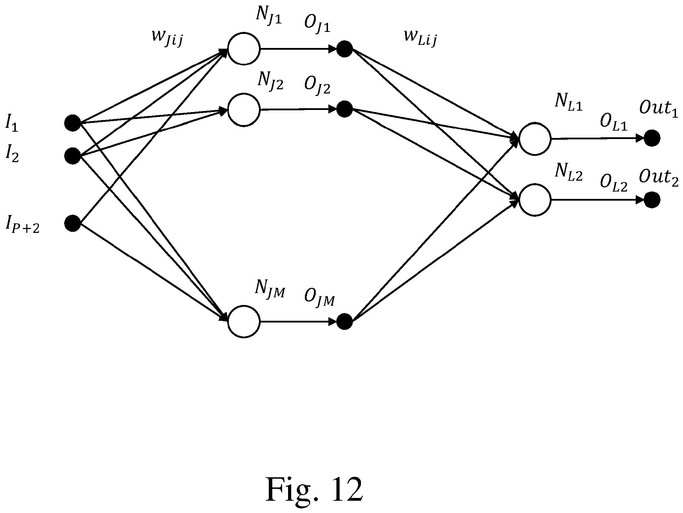

**Fig. 12** represents a neural network implementation of the means for comparing the estimated pattern of envelopes to the memorized pattern of envelopes.

According to invention, the server 150 feeds the neural network with a number n of inputs $I_1$ to $I_n$ comprising the P envelope levels comprised in the measured pattern and the reported operation conditions and motor type. In Fig.12, the inputs $I_1$ or $I_2$ or $I_{P+2}$, of the neural network also comprise two parameters of operating conditions: motor speed and torque. In a variant, the operating conditions could contain additional parameters, such as switching frequency, modulation type, motor type, etc.

A number M of Neurons $N_{J1}$, $N_{J2}$, ... $N_{JM}$ of the hidden layer of the neural network processes the neural network input information, each neuron producing an output hidden layer signal $O_{J1}$, $O_{J2}$, ... $O_{JM}$. As example, M = 1000.

As example, each neuron $N_{Jk}$, with k=1 to M, produces an output signal $O_{Jk}$ from the input using neuron formula:

$$O_{Jk} = g_J\left(\sum_{i=1}^{n} w_{Jik} \cdot I_i\right)$$

Where $g_J$ is an activation function and $\{w_{Jik}\}$ are predetermined synaptic weights of the neuron $N_{Jk}$.

As example, $g_J(x)$ is a sigmoid activation function. $g_J(x) = \frac{1}{1+e^{-x}}$

Two output Neurons $N_{L1}$, $N_{L2}$ then process the M output hidden layer signals $O_{J1}$, $O_{J2}$, ... $O_{JM}$ in order to produce the outputs $O_{L1}$, $O_{L2}$ of neural network.

The first output $O_{L1}$ represents the state of detection of presence of the fault determined from the input pattern. It is processed according to formula

$$O_{L1} = g_{L1}\left(\sum_{j=1}^{m} w_{Lj1} \cdot O_{Jj}\right)$$

Where $g_{L1}$ is a step activation function and $\{w_{Lj1}\}$ are predetermined synaptic weights of the neuron $N_{L1}$.
As example,

$$\begin{cases} \forall x \leq 0, g_J(x) = 0 \\ \forall x > 0, g_J(x) = 1 \end{cases}$$

The second output $O_{L2}$ represents the fault level determined from the input pattern. It is processed according to formula

$$O_{L2} = g_{L2}\left(\sum_{j=1}^{m} w_{Lj2} \cdot O_{Jj}\right)$$

Where $g_{L2}$ is an activation function and $\{w_{Lj2}\}$ are predetermined synaptic weights of the neuron $N_{L2}$.
As example, $g_{L2}(x)$ is a sigmoid activation function. $g_J(x) = \frac{1}{1+e^{-x}}$
The weights of neural network $\{w_{Jik}\}$, $\{w_{Lj1}\}$, $\{w_{Lj2}\}$ are predetermined from a training population of patterns with known operating conditions, fault type and/or fault level. As example, weights are determined using back-propagation training algorithm.
Fault detection and fault level identification with Neural network can either be implemented by software or in hardware.

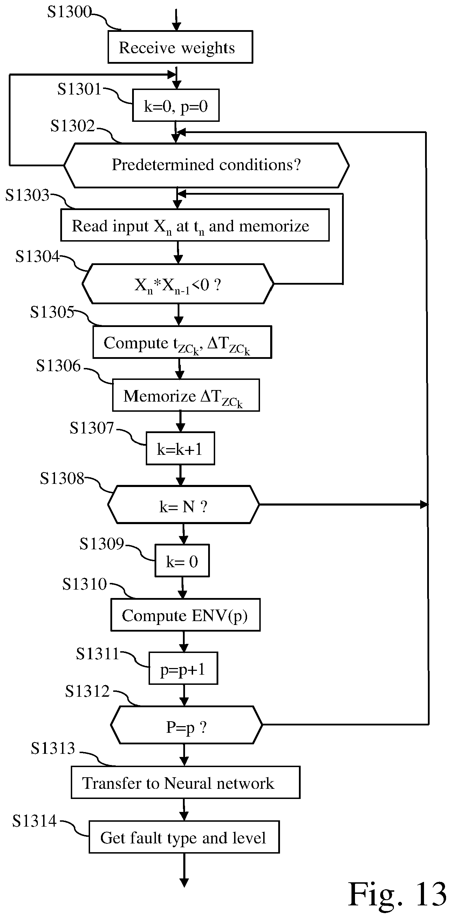

**Fig. 13** represents a second example of an algorithm, executed by a device for monitoring the condition of a motor, for monitoring the condition of the motor according to the second mode of realization of the present invention.
The present algorithm is disclosed in an example wherein it is executed by the processor 200 of the device for monitoring the condition of a motor 100.
At step S1300, the processor 200 receives weights of a neural network from the server 150. The weights $\{w_{Jik}\}$ $\{w_{Lj1}\}$, $\{w_{Lj2}\}$ are predetermined by the server from a training population of patterns with known operating conditions, fault type and fault level, using back-propagation training algorithm.
At step S1301, the processor 200 sets the variables k and p to null value.
At next step S1302, the processor 200 checks if the motor operates in predetermined conditions. For example, predetermined operating conditions are constant speed and torque. The processor 200 detects the variation of speed and torque from the variation of average frequency and amplitude of the sensed signal. The motor is in predetermined operating conditions when the average frequency and amplitude of the sensed signal are stable.
In a variant, the predetermined operating conditions are constant torque and constant speed ramp. In yet another variant, the predetermined operating conditions are cyclic speed and torque.
If the motor is in predetermined operating conditions, the processor 200 moves to step S1303. Otherwise, the processor 200 returns to step S 1301.
At step S1303, the processor 200 obtains from the I/O interface 205 at time $t_n$ the signal value noted $X_n$ representative of the current flowing through one phase connector of the motor 120 where n is an indicia that is incremented each time the signal value is sensed and memorizes $t_n$ and $X_n$.
It has to be noted here that the step S1303 may be executed prior to step S 1302 and the signal value is used to determine if the motor operates in predetermined conditions.
At next step, S 1304 checks if the signs of the current value $X_n$ and of current value $X_{n-1}$ obtained at the previous iteration are different.
If the signs of the current values $X_n$ and $X_{n-1}$ are different, a zero cross voltage is detected and the processor 200 moves to step S 1305. Otherwise, the processor 200 returns to step S 1303 in order to measure following currents values $x_{n+1}$.
At step S 1305, the processor 200 calculates the zero-crossing instant $t_{zCk}$ and the time interval $\Delta T_{zCk}$ between

the zero-crossing instant and the previously calculated zero-crossing instant:

$$t_{zC_k} = t_{n-1} - \frac{t_n - t_{n-1}}{X_n - X_{n-1}} X_{n-1}$$

$$\Delta T_{zC_k} = t_{zC_k} - t_{zC_{k-1}}$$

At next step S 1306, the processor 200 memorizes the time difference $\Delta T_{zCk}$.

At next step S 1307, the processor 200 increments the variable k by one.

A next step S 1308, the processor 200 checks if the variable k is equal to a first predetermined value N. For example, N is equal to 50.

In a variant, the predetermined value is computed from the speed of predetermined conditions estimated at step S 1302, so that N zero-crossings correspond to a fixed duration. As example, the fixed duration is one second.

If the variable k is equal to N, the processor 200 moves to step S1309. Otherwise, the processor 200 returns to step S1302.

At step S1309, the processor 200 sets the variable k to null value.

At next step S1310 the processor 200 determines an envelope ENV(p) of the N time intervals $\Delta T_{zCk}$. As example, the envelope is the standard deviation:

$$ENV(p) = \sqrt{\frac{1}{N-1} \sum_{k \leq N} \left( \Delta T_{zC_k} - \frac{1}{N} \sum_{k \leq N} \Delta T_{zC_k} \right)^2}$$

As another example, the envelope is the maximum among the N intervals $\Delta T_{zCk}$. At next step S1311, the processor 200 increments the variable p by one.

A next step S1312, the processor 200 checks if the variable p is equal to a second predetermined value P. P is for example equal to 20.

If p is equal to P, the processor 200 moves to step S 1313. Otherwise, the processor 200 returns to step S1302.

At step S1313, a pattern of P stored envelopes values is obtained and the processor 200 transfers the received P stored envelopes values together with the motor conditions to a neural network comprised in the device for monitoring the condition of a motor the coefficients of which have being received at step 1300. The neural network is as one disclosed in Fig. 12.

At step S 1314, the processor 300 receives, from the neural network, information indicating if a fault exists for the motor.

If a fault exists, a fault signal like a sound or a visual signal is generated.

Naturally, many modifications can be made to the embodiments of the invention described above. The scope of the invention is defined by the appended claims.

## Claims

1. A method for monitoring the condition of a motor, the motor being driven by a power source (110) that provides signals to the motor, wherein the method is carried out by the device (100) of claim 10 or the system of claim 11 and comprises the steps of:

    - sensing a motor signal,
    - detecting (S401) operating conditions of the motor, and if the motor operates in predetermined conditions:
    - detecting (S402, S403) the instants of zero-crossing of the sensed signal,
    - determining (S404) the time intervals between two zero-crossing instants,
    - estimating (S409) plural envelopes of the determined time intervals in order to obtain an estimated pattern of envelopes, each envelope being determined over a number of determined time intervals,
    - determining (S415) from the operating conditions of the motor and the pattern of envelopes if the motor has a fault and/or a level of the fault.

2. The method according to claim 1, wherein the step of determining if the motor has a fault and/or a level of the fault is performed by comparing, if a pattern of envelopes with same predetermined operating conditions is memorized, the estimated pattern of envelopes to the memorized pattern of envelopes with same predetermined operating conditions.

3. The method according to claim 3, wherein the method further comprises the step of memorizing the estimated pattern of envelopes if no pattern of envelopes with same predetermined operating conditions is memorized.

4. The method according to claim 1, wherein the step of determining if the motor has a fault and/or a level of the fault is performed using a neural network and in that weights used by the neural network are received by a server.

5. The method according to claims 1 to 4, wherein the method is executed by a device for monitoring the condition of a motor.

6. The method according to claim 3, wherein the steps of sensing the motor signal, detecting predetermined operating conditions of the motor, detecting the instants of zero-crossing of the sensed signals, determining the time intervals between two zero-crossing instants, estimating plural envelopes of the determined time intervals in order to obtain a pattern of envelopes, are executed by a device for monitoring the condition of a motor.

7. The method according to claim 6, wherein the method comprises further step of transferring to a server through a communication network the estimated envelopes, the operating conditions of the motor and information identifying the motor.

8. The method according to claim 7, wherein the step of determining from the operating conditions of the motor and the pattern of envelopes if the motor has a fault and/or a level of the fault is executed by the server.

9. The method according to claim 8, wherein the step of determining from the operating conditions of the motor and the pattern of envelopes if the motor has a fault and/or a level of the fault is performed by a neural network comprised in the server.

10. A device (100) for monitoring the condition of a motor, the motor being driven by a power source (110) that provides signals to the motor, wherein the device comprises:

   - means for sensing a motor signal,
   - means for detecting predetermined operating conditions of the motor, and if the motor operates in predetermined conditions:
   - means for detecting the instants of zero-crossing of the sensed signal,
   - means for determining the time intervals between two zero-crossing instants,
   - means for estimating plural envelopes of the determined time intervals in order to obtain a pattern of envelopes, each envelope being determined over a number of determined time intervals,
   - means for determining from the operating conditions of the motor and the pattern of envelopes if the motor has a fault and/or a level of the fault.

11. A system for monitoring the condition of a motor, the motor being driven by a power source (110) that provides signals to the motor, wherein the system comprises:

   - a device (100) for monitoring the condition of the motor,
   - a server (150),
   - means, included in the device for monitoring the condition of a motor, for sensing a motor signal,
   - means, included in a device for monitoring the condition of a motor, for detecting predetermined operating conditions of the motor, and if the motor operates in predetermined conditions:
   - means, included in the device for monitoring the condition of a motor, for detecting the instants of zero-crossing of the sensed signal,
   - means, included in the device for monitoring the condition of a motor, for determining the time intervals between two zero-crossing instants,
   - means, included in the device for monitoring the condition of a motor, for estimating plural envelopes of the determined time intervals in order to obtain a pattern of envelopes, each envelope being determined over a number of determined time intervals,

- means, included in the device for monitoring the condition of a motor, for transferring to a server through a communication network the estimated envelopes, the operating conditions of the motor and information identifying the motor,
- means, included in the server, for determining from the operating conditions of the motor and the pattern of envelopes if the motor has a fault and/or a level of the fault.

**Patentansprüche**

1. Verfahren zum Überwachen des Zustands eines Motors, wobei der Motor von einer Stromquelle (110) angetrieben wird, die Signale für den Motor bereitstellt, wobei das Verfahren von der Vorrichtung (100) nach Anspruch 10 oder dem System nach Anspruch 11 ausgeführt wird und die folgenden Schritte umfasst:

   - Messen eines Motorsignals,
   - Erfassen (S401) von Betriebsbedingungen des Motors und ob der Motorbetrieb unter vorbestimmten Bedingungen abläuft:
   - Erfassen (S402, S403) der Zeitpunkte des Nulldurchgangs des gemessenen Signals,
   - Bestimmen (S404) der Zeitintervalle zwischen zwei Nulldurchgangszeitpunkten,
   - Schätzen (S409) mehrerer Hüllkurven der bestimmten Zeitintervalle zum Erhalten eines geschätzten Musters von Hüllkurven, wobei jede Hüllkurve über eine Anzahl von bestimmten Zeitintervallen bestimmt wird,
   - Bestimmen (S415), aus den Betriebsbedingungen des Motors und dem Muster von Hüllkurven, ob der Motor einen Fehler und/oder einen Grad des Fehlers aufweist.

2. Verfahren nach Anspruch 1, wobei der Schritt des Bestimmens, ob der Motor einen Fehler und/oder einen Grad des Fehlers aufweist, durch Vergleichen, wenn ein Muster von Hüllkurven mit gleichen vorbestimmten Betriebsbedingungen gespeichert ist, des geschätzten Musters von Hüllkurven mit geschätzten Musters von Hüllkurven mit dem gespeicherten Muster von Hüllkurven mit gleichen vorbestimmten Betriebsbedingungen durchgeführt wird.

3. Verfahren nach Anspruch 3, wobei das Verfahren ferner den Schritt des Speicherns des geschätzten Musters von Hüllkurven umfasst, wenn kein Muster von Hüllkurven mit gleichen vorbestimmten Betriebsbedingungen gespeichert ist.

4. Verfahren nach Anspruch 1, wobei der Schritt des Bestimmens, ob der Motor einen Fehler und/oder einen Grad des Fehlers aufweist, unter Verwendung eines neuronalen Netzes durchgeführt wird und dass, die vom neuronalen Netz verwendeten Gewichte von einem Server empfangen werden.

5. Verfahren nach einem der Ansprüche 1 bis 4, wobei das Verfahren durch eine Vorrichtung zum Überwachen des Zustands eines Motors ausgeführt wird.

6. Verfahren nach Anspruch 3, wobei die Schritte des Messens des Motorsignals, des Erfassens vorbestimmter Betriebsbedingungen des Motors, des Erfassens der Zeitpunkte des Nulldurchgangs der gemessenen Signale, des Bestimmens der Zeitintervalle zwischen zwei Nulldurchgangszeitpunkten, des Schätzens mehrerer Hüllkurven der bestimmten Zeitintervalle zum Erhalten eines Musters von Hüllkurven von einer Vorrichtung zum Überwachen des Zustands eines Motors ausgeführt werden.

7. Verfahren nach Anspruch 6, wobei das Verfahren einen weiteren Schritt umfasst, bei dem die geschätzten Hüllkurven, die Betriebsbedingungen des Motors und Informationen zum Identifizieren des Motors über ein Kommunikationsnetz an einen Server übertragen werden.

8. Verfahren nach Anspruch 7, wobei der Schritt des Bestimmens, aus den Betriebsbedingungen des Motors und dem Muster von Hüllkurven, ob der Motor einen Fehler und/oder einen Grad des Fehlers aufweist, vom Server ausgeführt wird.

9. Verfahren nach Anspruch 8, wobei der Schritt des Bestimmens, aus den Betriebsbedingungen des Motors und dem Muster von Hüllkurven, ob der Motor einen Fehler und/oder einen Grad des Fehlers aufweist, von einem neuronalen Netz durchgeführt wird, das im Server enthalten ist.

10. Vorrichtung (100) zum Überwachen des Zustands eines Motors, wobei der Motor von einer Stromquelle (110) angetrieben wird, die Signale für den Motor bereitstellt, wobei die Vorrichtung umfasst:

- Mittel zum Messen eines Motorsignals,
- Mittel zum Erfassen von vorbestimmten Betriebsbedingungen des Motors und ob der Motorbetrieb unter vorbestimmten Bedingungen abläuft:
- Mittel zum Erfassen der Zeitpunkte des Nulldurchgangs des gemessenen Signals,
- Mittel zum Bestimmen der Zeitintervalle zwischen zwei Nulldurchgangszeitpunkten,
- Mittel zum Schätzen mehrerer Hüllkurven der bestimmten Zeitintervalle zum Erhalten eines Musters von Hüllkurven, wobei jede Hüllkurve über eine Anzahl von bestimmten Zeitintervallen bestimmt wird,
- Mittel zum Bestimmen, aus den Betriebsbedingungen des Motors und dem Muster von Hüllkurven, ob der Motor einen Fehler und/oder einen Grad des Fehlers aufweist.

11. System zum Überwachen des Zustands eines Motors, wobei der Motor von einer Stromquelle (110) angetrieben wird, die Signale für den Motor bereitstellt, wobei das System umfasst:

- eine Vorrichtung (100) zum Überwachen des Zustands des Motors,
- einen Server (150),
- Mittel, die in der Vorrichtung zum Überwachen des Zustands eines Motors beinhaltet sind, zum Messen eines Motorsignals,
- Mittel, die in der Vorrichtung zum Überwachen des Zustands eines Motors beinhaltet sind, zum Erfassen von vorbestimmten Betriebsbedingungen des Motors und ob der Motorbetrieb unter vorbestimmten Bedingungen abläuft:
- Mittel, die in der Vorrichtung zum Überwachen des Zustands eines Motors beinhaltet sind, zum Erfassen der Zeitpunkte des Nulldurchgangs des gemessenen Signals,
- Mittel, die in der Vorrichtung zum Überwachen des Zustands eines Motors beinhaltet sind, zum Bestimmen der Zeitintervalle zwischen zwei Nulldurchgangszeitpunkten,
- Mittel, die in der Vorrichtung zum Überwachen des Zustands eines Motors beinhaltet sind, zum Schätzen mehrerer Hüllkurven der bestimmten Zeitintervalle zum Erhalten eines Musters von Hüllkurven, wobei jede Hüllkurve über eine Anzahl von bestimmten Zeitintervallen bestimmt wird,
- Mittel, die in der Vorrichtung zum Überwachen des Zustands eines Motors beinhaltet sind, zum Übertragen der geschätzten Hüllkurven, der Betriebsbedingungen des Motors und von Informationen zur Identifizierung des Motors an einen Server über ein Kommunikationsnetz
- Mittel, die im Server beinhaltet sind, zum Bestimmen, aus den Betriebsbedingungen des Motors und dem Muster von Hüllkurven, ob der Motor einen Fehler und/oder einen Grad des Fehlers aufweist.

## Revendications

1. Procédé pour surveiller l'état d'un moteur, ce moteur étant entraîné par une source d'alimentation électrique (110) qui fournit des signaux au moteur, ce procédé étant exécuté par le dispositif (100) selon la revendication 10 ou par le système selon la revendication 11 et comprenant les étapes suivantes :

- la détection d'un signal du moteur,
- la détection (S401) des conditions de fonctionnement du moteur, et, si le moteur fonctionne dans des conditions prédéterminées :

- la détection (S402, S403) des instants de passage par zéro du signal détecté,
- la détermination (S404) des intervalles de temps entre les instants de passage par zéro,
- l'estimation (S409) de plusieurs enveloppes des intervalles de temps déterminés afin d'obtenir un motif d'enveloppes estimé, chaque enveloppe étant déterminée sur un nombre d'intervalles de temps déterminés,
- la détermination (S415), à partir des conditions de fonctionnement du moteur et du motif d'enveloppes, de si le moteur a un défaut et/ou d'un niveau de ce défaut.

2. Procédé selon la revendication 1, dans lequel l'étape de détermination de si le moteur a un défaut et/ou d'un niveau de ce défaut est exécutée en comparant, si un motif d'enveloppes avec les mêmes conditions de fonctionnement prédéterminées est mémorisé, le motif d'enveloppes estimé avec le motif d'enveloppes mémorisé avec les mêmes conditions de fonctionnement prédéterminées.

3.  Procédé selon la revendication 3, ce procédé comprenant en outre l'étape de mémorisation du motif d'enveloppes estimé si aucun motif d'enveloppes avec les mêmes conditions de fonctionnement prédéterminées n'est mémorisé.

4.  Procédé selon la revendication 1, dans lequel l'étape de détermination de si le moteur a un défaut et/ou d'un niveau de ce défaut est exécutée en utilisant un réseau neuronal et en ce que les poids utilisés par ce réseau neuronal sont reçus par un serveur.

5.  Procédé selon les revendications 1 à 4, ce procédé étant exécuté par un dispositif pour surveiller l'état d'un moteur.

6.  Procédé selon la revendication 3, dans lequel les étapes de détection du signal du moteur, de détection des conditions de fonctionnement prédéterminées du moteur, de détection des instants de passage par zéro des signaux détectés, de détermination des intervalles de temps entre deux instants de passage par zéro, d'estimation de plusieurs enveloppes des intervalles de temps déterminés afin d'obtenir un motif d'enveloppes, sont exécutées par un dispositif pour surveiller l'état d'un moteur.

7.  Procédé selon la revendication 6, ce procédé comprenant une étape supplémentaire consistant à transférer à un serveur, au moyen d'un réseau de communication, les enveloppes estimées, les conditions de fonctionnement du moteur et des informations identifiant le moteur.

8.  Procédé selon la revendication 7, dans lequel l'étape de détermination, à partir des conditions de fonctionnement du moteur et du motif d'enveloppes, de si le moteur a un défaut et/ou d'un niveau de ce défaut est exécutée par le serveur.

9.  Procédé selon la revendication 8, dans lequel l'étape de détermination, à partir des conditions de fonctionnement du moteur et du motif d'enveloppes, de si le moteur a un défaut et/ou d'un niveau de ce défaut est exécutée par un réseau neuronal compris dans le serveur.

10. Dispositif pour surveiller l'état d'un moteur, ce moteur étant entraîné par une source d'alimentation électrique (100) qui fournit des signaux au moteur, ce dispositif comprenant :

    - un moyen pour détecter un signal du moteur,
    - un moyen pour détecter les conditions de fonctionnement prédéterminées du moteur, et, si le moteur fonctionne dans les conditions prédéterminées :

        - un moyen pour détecter les instants de passage par zéro du signal détecté,
        - un moyen pour déterminer les intervalles de temps entre deux instants de passage par zéro,
        - un moyen pour estimer plusieurs enveloppes des intervalles de temps déterminés afin d'obtenir un motif estimé d'enveloppes, chaque enveloppe étant déterminée sur un nombre d'intervalles de temps déterminés,
        - un moyen pour déterminer, à partir des conditions de fonctionnement du moteur et du motif d'enveloppes, si le moteur a un défaut et/ou un niveau de ce défaut.

11. Système pour surveiller l'état d'un moteur, ce moteur étant entraîné par une source d'alimentation électrique (110) qui fournit des signaux au moteur, ce système comprenant :

    - un dispositif (100) pour surveiller l'état du moteur,
    - un serveur (150),
    - un moyen, compris dans le dispositif pour surveiller l'état d'un moteur, pour détecter un signal du moteur,
    - un moyen, compris dans le dispositif pour surveiller l'état d'un moteur, pour détecter les conditions de fonctionnement prédéterminées du moteur, et, si le moteur fonctionne dans les conditions prédéterminées :

        - un moyen, compris dans le dispositif pour surveiller l'état d'un moteur, pour détecter les instants de passage par zéro du signal détecté,
        - un moyen, compris dans le dispositif pour surveiller l'état d'un moteur, pour déterminer les intervalles de temps entre deux instants de passage par zéro,
        - un moyen, compris dans le dispositif pour surveiller l'état d'un moteur, pour estimer plusieurs enveloppes des intervalles de temps déterminés afin d'obtenir un motif d'enveloppes, chaque enveloppe étant déterminée sur un nombre d'intervalles de temps déterminés,
        - un moyen, compris dans le dispositif pour surveiller l'état d'un moteur, pour transférer à un serveur, au moyen d'un réseau de communication, les enveloppes estimées, les conditions de fonctionnement du moteur et des informations identifiant le moteur,
- un moyen, compris dans le serveur, pour déterminer, à partir des conditions de fonctionnement du moteur et du motif d'enveloppes, si le moteur a un défaut et/ou un niveau de ce défaut.

Fig. 1a

Fig. 1b

Fig. 2

Fig. 3

S400 — k=0, p=0

S401 — Predetermined conditions?

S402 — Read input $X_n$ at $t_n$ and memorize

S403 — $X_n * X_n - 1 < 0$ ?

S404 — Compute $t_{ZC_k}$, $\Delta T_{ZC_k}$

S405 — Memorize $\Delta T_{ZC_k}$

S406 — k=k+1

S407 — k= N ?

S408 — k= 0

S409 — Compute ENV(p)

S410 — p=p+1

S411 — P=p ?

S413 — Known pattern?

S414 — Memorize pattern and conditions

S415 — Detect default pattern

Fig. 4

Fig. 5

S500 — k=0, p=0

S501 — Predetermined conditions?

S502 — Read input $X_n$ at $t_n$ and memorize

S503 — $X_n * X_{n-1} < 0$ ?

S504 — Compute $t_{ZC_k}$, $\Delta T_{ZC_k}$

S505 — Memorize $\Delta T_{ZC_k}$

S506 — k=k+1

S507 — k= N ?

S508 — k= 0

S509 — Compute ENV(p)

S510 — p=p+1

S511 — P=p ?

S512 — Transfer pattern

S602 — Store receive pattern

S600 — Receive pattern

S601 — Know corresponding fault level and type?

S603 — Get fault type and level

# Fig. 6

S700 — Receive pattern

S701 — Transfer to Neural network

S703 — Get fault type and level

# Fig. 7

Fig. 8

Fig. 9

$N$

$\Delta t_{ZC(n)}$

$n \leq NP$

## Fig. 10a

$P$ enveloppe points

0

$p \leq P$

## Fig. 10b

$\Delta t_{ZC(n)}$

$N$

$n \leq NP$

## Fig. 11a

$P$ enveloppe points

$ENV(p)$

0

$p \leq P$

## Fig. 11b

Fig. 12

S1300 — Receive weights

S1301 — k=0, p=0

S1302 — Predetermined conditions?

S1303 — Read input $X_n$ at $t_n$ and memorize

S1304 — $X_n * X_{n-1} < 0$ ?

S1305 — Compute $t_{ZC_k}$, $\Delta T_{ZC_k}$

S1306 — Memorize $\Delta T_{ZC_k}$

S1307 — k=k+1

S1308 — k= N ?

S1309 — k= 0

S1310 — Compute ENV(p)

S1311 — p=p+1

S1312 — P=p ?

S1313 — Transfer to Neural network

S1314 — Get fault type and level

Fig. 13

**REFERENCES CITED IN THE DESCRIPTION**

**Patent documents cited in the description**

- CN 106680700